# FASCICULE DE BREVET EUROPEEN

(11) **EP 0 596 771 B1**
(45) Date de publication et mention de la délivrance du brevet: **08.01.1997**
(21) Numéro de dépôt: 93402616.2
(22) Date de dépôt: 26.10.1993
(51) Int. Cl.: H01R 9/09, H01R 13/24, H01R 23/68

(54) **Dispositif de connexion électrique pour circuits imprimés dont au moins l'un est souple**
Anordnung zum elektrischen Verbinden von gedruckten Leiterplatten, von denen mindestens eine biegsam ist
Device for electric connection of printed circuit boards at least one of which is flexible

(30) Priorité: 04.11.1992 FR 9213201
(43) Date de publication de la demande: 11.05.1994
(73) Titulaire: AEROSPATIALE Société Nationale Industrielle, 75781 Paris Cédex 16 (FR)
(72) Inventeur: Barre, Albert, F-78125 La Vieille Eglise en Yvelines (FR)
(74) Mandataire: Bonnetat, Christian

(56) Documents cités:
- EP-A- 0 491 269
- US-A- 3 924 915
- US-A- 3 954 317
- US-A- 4 693 529

## Description

La présente invention concerne les dispositifs de connexion électrique pour des supports isolants, porteurs de circuits imprimés, dont au moins l'un est souple.

On sait que, généralement, pour la connexion de tels supports, on utilise des connecteurs munis de fiches femelles, dans lesquelles viennent s'enficher des fiches mâles agencées sur lesdits supports. Pour réaliser un bon contact, il est nécessaire d'établir une pression de contact élevée entre la fiche mâle et la fiche femelle de chaque couple de contacts. La mise en contact se faisant à force, il se produit une usure des fiches diminuant l'efficacité de la connexion après un certain nombre de manoeuvres d'enfichage et de désenfichage. Lorsqu'il est possible, le remplacement desdites fiches est délicat et fort coûteux, et il en est de même de la mise en oeuvre d'une protection superficielle contre l'usure, comme par exemple le recouvrement des fiches par un métal résistant à l'usure.

La présente invention a pour but de remédier à ces inconvénients et concerne un dispositif de connexion ne mettant en jeu aucun frottement d'insertion, lors de la mise en contact électrique des supports, porteurs de circuits imprimés. Le dispositif de connexion conforme à la présente invention est spécialement adapté à une connexion, pour laquelle au moins l'un des supports est souple.

Le dispositif de connexion électrique selon l'invention, destiné à connecter des supports isolants, porteurs de circuits imprimés, dont au moins l'un est souple, chacun desdits supports étant muni sur une de ses faces de contacts destinés à la connexion, est remarquable en ce que lesdits contacts font saillie par rapport à la face desdits supports qui les porte et en ce que ledit dispositif de connexion électrique comporte une couche de matière élastiquement déformable, susceptible d'exercer une pression sur la face non pourvue de contacts dudit support souple, afin de le presser contre au moins un autre desdits supports, qui est en appui contre un élément rigide, de sorte que chaque contact, destiné à être connecté, dudit support souple est mis en contact avec un contact, destiné à être connecté, d'un autre desdits supports.

La présente invention élimine donc les problèmes dus aux frottements d'insertion, en créant un dispositif de connexion dans lequel la connexion électrique ne résulte pas de l'insertion d'un élément dans un autre élément, mais de la simple mise en contact de deux éléments, en l'occurrence la mise en contact de deux contacts agencés sur les faces des supports à connecter.

Les supports à connecter sont disposés les uns en regard des autres de sorte que chaque contact, destiné à la connexion, d'un desdits supports, se trouve face à un contact, destiné à la connexion, d'un autre desdits supports.

On remarquera, toutefois, que le simple fait de presser, dans une telle position, l'un desdits supports contre un autre desdits supports qui lui fait face, ne garantirait pas la mise en contact de toutes les paires de contacts associés. Il se pourrait, en effet, qu'un contact protubérant soit moins saillant que les contacts qui lui sont voisins, et qu'en exerçant une pression uniforme, lesdits contacts voisins arrivent au contact des contacts qui leurs sont associés, tandis que ledit contact moins saillant n'atteigne pas le contact qui lui est associé, ménageant un espacement avec celui-ci.

Selon l'invention, le dispositif de connexion électrique permet alors, grâce à ladite couche de matière élastiquement déformable, d'exercer une pression sur la face non pourvue de contacts du support souple, en face du contact qui est moins saillant, telle que ledit support souple se déforme localement afin de combler ledit espacement et assurer la mise en contact dudit contact moins saillant avec son contact associé.

La pression appliquée est ainsi répartie le long du support souple de manière à obtenir une pression adéquate au niveau de chaque contact pour permettre la connexion électrique de tous les contacts protubérants, destinés à la connexion, en compensant les inégalités de hauteur éventuelles desdits contacts.

Cette répartition de la pression est obtenue grâce à l'élasticité de ladite couche de matière élastiquement déformable, par exemple un élastomère, pressée contre ledit support souple. En effet, suivant les points de contact, l'épaisseur de ladite couche varie, entraînant une déformation de sa surface qui est pressée contre le support souple. Ce dernier reproduit la même déformation, permettant alors de remédier aux différences entre les espacements séparant les différents contacts associés.

Il est à noter qu'un espacement variable entre les extrémités de contacts associés, tel que mentionné ci-dessus, pourrait également être dû à un manque de planéité de la surface pourvue de contacts d'un desdits supports. Un contact qui se trouverait, par exemple, dans un creux de la surface, bien qu'étant de même longueur que ses contacts voisins, présenterait une extrémité qui serait en retrait par rapport aux extrémités desdits contacts voisins.

De façon avantageuse, ledit dispositif de connexion électrique comporte une plaque de pression qui porte ladite couche de matière élastiquement déformable par sa face qui n'est pas en contact avec le support souple et qui est, par exemple, soumise à la pression d'un ressort, qui assure la pression de contact.

Selon un mode de réalisation avantageux, ledit dispositif de connexion électrique comporte, d'une part, un boîtier contenant ladite plaque de pression et ledit ressort et dégageant ladite couche de matière élastiquement déformable, et, d'autre part, un couvercle rigide pouvant être accouplé audit boîtier en regard de ladite couche de matière élastiquement déformable.

Par ailleurs, ledit dispositif de connexion électrique peut être muni de moyens de guidage complémentaires, par exemple des pions de positionnement agencés sur ledit boîtier et des évidements pratiqués dans ledit couvercle, guidant les mouvements de rapprochement et d'éloignement dudit couvercle par rapport audit boîtier. Lesdits pions de positionnement peuvent, en outre, être destinés à favoriser le positionnement des supports sur le boîtier, lesdits supports présentant des trous et venant se placer par l'intermédiaire de ces derniers sur lesdits pions de positionnement.

Avantageusement, ledit boîtier et ledit couvercle rigide peuvent également être munis d'un système de fixation par vis facilitant la mise en place et la maintenance dudit dispositif de connexion.

Les figures du dessin annexé feront bien comprendre comment l'invention peut être réalisée. Sur ces figures, des références identiques désignent des éléments semblables.

La figure 1 est une vue en coupe schématique agrandie illustrant la connexion électrique entre un support souple et un support rigide, conformément à l'invention.

La figure 2 montre partiellement en coupe deux supports munis de contacts disposés en regard l'un de l'autre.

La figure 3 montre également en coupe partielle deux supports disposés en regard l'un de l'autre, dont l'un présente un creux de surface.

La figure 4 est une vue en coupe transversale d'un mode de réalisation de la présente invention, selon la ligne IV-IV de la figure 5.

La figure 5 est une vue en coupe, selon la ligne V-V de la figure 4.

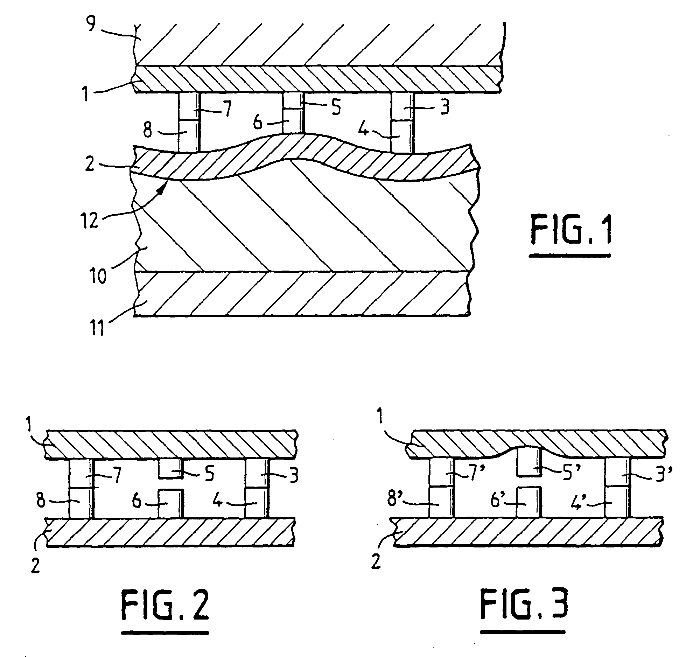

Le dispositif de connexion électrique, conforme à la présente invention et représenté schématiquement et partiellement sur la figure 1, est destiné à connecter électriquement des supports isolants 1 et 2, porteurs de circuits imprimés, et munis de contacts 3, 4, 5, 6, 7 et 8 qui font saillie par rapport à la surface desdits supports. Lesdits contacts présentent un même agencement sur chacun desdits supports 1 et 2, de sorte que chaque contact 3, 5, 7 du support 1 peut être amené en regard d'un contact 4, 6, 8 du support 2, lorsque les deux supports sont disposés l'un en regard de l'autre.

Le support 1 prend appui sur un élément rigide 9. Le support 2 est pressé contre ledit support 1 par une couche 10 de matière élastiquement déformable, par exemple un élastomère, soumise à la pression d'une plaque de pression 11. Ledit support pressé 2 est souple, tandis que l'autre support 1, qui prend appui sur l'élément rigide 9 et qui ne subit, par conséquent, aucune déformation, même s'il est souple, peut être soit souple, soit rigide.

Dans la situation représentée sur la figure 2, le contact 5 est moins saillant que les contacts voisins 3 et 7. Lorsque l'on dispose les supports 1 et 2 l'un contre l'autre, les contacts 3 et 7 arrivent respectivement au contact des contacts 4 et 8 qui leur sont associés, tandis que le contact 5 n'est pas assez saillant pour atteindre le contact 6 qui lui est associé. La distance séparant deux contacts est encore plus importante lorsque chacun des deux contacts associés est moins saillant que ses voisins.

Grâce à l'invention, la mise en contact des contacts 5 et 6 est obtenue par déformation du support souple 2 sous l'action de la couche 10 de matière élastiquement déformable. Ledit support souple 2 reproduit, en effet, la forme de la surface de pression 12 de ladite couche 10. Cette dernière, lorsqu'elle est pressée contre le support souple 2, acquiert, grâce à son élasticité, une épaisseur variable en fonction de la localisation des contacts du support souple qui sont en appui sur leurs contacts associés.

A partir d'une certaine pression, la surface de pression 12 et le support souple 2 présentent une configuration telle que tous les contacts du support souple 2 prennent appui contre les contacts du support 1 qui leur sont associés.

L'espacement indésirable entre deux contacts associés, en position rapprochée de contact desdits supports 1 et 2, peut provenir, soit comme représenté sur la figure 2 et mentionné précédemment, d'une plus faible hauteur de l'un au moins 5 des contacts, soit comme représenté sur la figure 3, d'un manque de planéité de la surface du support 1 pourvue de contacts, un contact 5' se trouvant alors dans un creux de ladite surface. Dans ce dernier cas, les contacts 3', 4', 5', 6', 7' et 8' agencés sur les supports 1 et 2 jouent le même rôle que les contacts 3, 4, 5, 6, 7 et 8 de la figure 2.

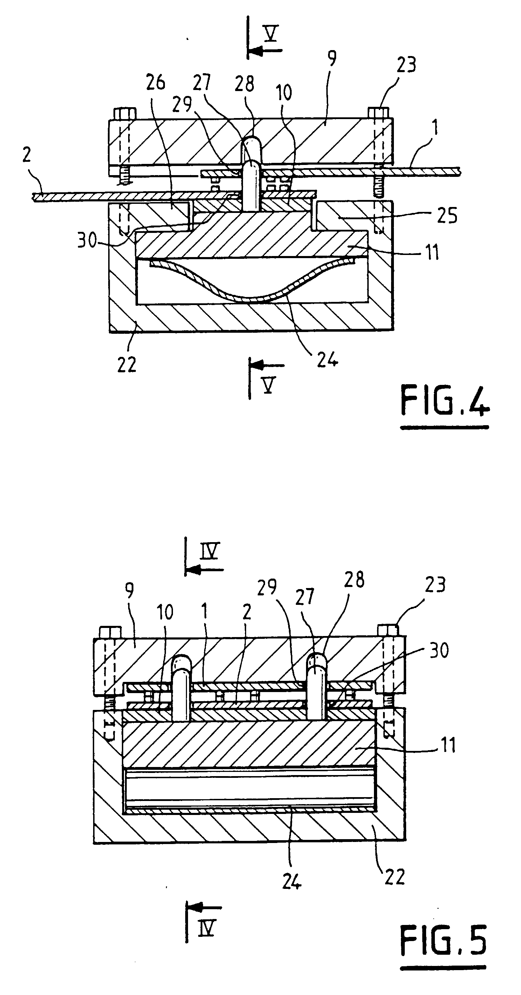

Selon le mode de réalisation des figures 4 et 5, le dispositif de connexion électrique conforme à la présente invention comporte un boîtier 22 et un couvercle rigide 9, qui est susceptible d'être fixé sur ledit boîtier 22 à l'aide de vis 23.

Ledit dispositif de connexion électrique comporte également un ressort à lame ondulée 24 logé dans le boîtier 22, prenant appui contre le fond de celui-ci et repoussant vers l'extérieur une plaque de pression 11. Ladite plaque de pression 11 est poussée par le ressort 24 contre des butées 25 et 26, qui sont agencées sur ledit boîtier 22, et qui la rendent prisonnière du boîtier 22. En outre, ladite plaque de pression 11 est recouverte d'une couche 10 de matière élastiquement déformable qui fait saillie à l'extérieur du boîtier, entre les butées 25 et 26.

Ledit dispositif de connexion électrique est destiné à connecter deux supports 1 et 2 munis tous les deux, sur une face de l'une de leurs extrémités, de contacts protubérants tels que ceux portant les références 3 à 8 et 3' à 8' des figures 1 à 3. Les extrémités munies de contacts desdits supports 1 et 2 sont disposées, face à face, sur ledit boîtier 22, le support 2 qui prend appui sur le boîtier 22 et sur la couche 10 de matière élastiquement déformable étant souple, l'autre support 1 pouvant être soit rigide, soit souple.

Lesdits supports 1 et 2 sont mis en place sur ledit boîtier 22 par l'intermédiaire de pions de positionnement saillants 27 agencés sur la plaque de pression 11 et destinés à se placer dans des trous 29 et 30, respectivement prévus sur lesdits supports 1 et 2. Ledit couvercle rigide 9, qui comporte sur sa face interne des évidements 28, destinés à le guider sur lesdits pions de positionnement 27, est vissé sur le boîtier 22, lorsque lesdits supports 1 et 2 sont en place sur ledit boîtier 22.

Les supports 1 et 2 se retrouvent alors dans la même situation que sur la figure 1. Ils sont, en effet, comprimés entre le couvercle rigide 9 et la couche 10 de matière élastiquement déformable. Le couvercle rigide 9 est vissé, jusqu'à ce que la pression exercée par ladite couche 10, sous l'action du ressort 24 et de la plaque de pression 11, soit suffisante pour permettre la connexion électrique entre tous les couples de contacts associés des deux supports 1 et 2.

## Revendications

1. Dispositif pour la connexion électrique de circuits imprimés, dont chacun est muni, sur une des faces de son support isolant (1,2) correspondant, de contacts (3 à 8, 3' à 8') destinés à la connexion,
caractérisé en ce que lesdits contacts font saillie par rapport à la face desdits supports qui les porte, en ce qu'au moins le support isolant (2) de l'un desdits circuits imprimés est souple, et en ce qu'une couche (10) de matière élastiquement déformable est prévue pour exercer une pression sur la face non pourvue de contacts dudit support souple (2), afin de le presser contre au moins un autre desdits supports (1), qui est en appui contre un élément rigide (9), de sorte que chaque contact (4,6,8,4',6',8'), destiné à être connecté, dudit support souple (2) est mis en contact avec un contact (3,5,7,3',5',7'), destiné à être connecté, d'un autre desdits supports (1).

2. Dispositif de connexion électrique selon la revendication 1,
caractérisé en ce que ladite couche (10) de matière élastiquement déformable est portée par une plaque de pression rigide (11).

3. Dispositif de connexion électrique selon la revendication 2,
caractérisé en ce que ladite plaque de pression rigide (11) est soumise à l'action d'un ressort (24).

4. Dispositif de connexion électrique selon l'une des revendications 1 à 3,
caractérisé en ce que ladite couche (10) de matière élastiquement déformable est constituée d'un élastomère.

5. Dispositif de connexion électrique selon l'une des revendications 3 ou 4,
caractérisé en ce qu'il comporte, d'une part, un boîtier (22) contenant ladite plaque de pression rigide (11) et ledit ressort (24) et dégageant ladite couche (10) de matière élastiquement déformable, et, d'autre part, un couvercle rigide (9) pouvant être accouplé audit boîtier (22) en regard de ladite couche (10) de matière élastiquement déformable.

6. Dispositif de connexion électrique selon la revendication 5,
caractérisé en ce que ledit boîtier (22) et ledit couvercle rigide (9) comportent des moyens de guidage complémentaires (27,28) guidant les mouvements de rapprochement et d'éloignement dudit couvercle rigide (9) par rapport audit boîtier (22).

7. Dispositif de connexion électrique selon la revendication 6,
caractérisé en ce que lesdits moyens de guidage complémentaires (27,28) comportent des pions de positionnement (27) et des évidements (28), respectivement prévus sur ledit boîtier (22) et ledit couvercle rigide (9).

8. Dispositif de connexion électrique selon la revendication 7,
caractérisé en ce que lesdits pions de positionnement (27) traversent des trous (29) et (30), respectivement pratiqués dans lesdits supports isolants 1 et 2, afin de positionner ces derniers par rapport audit boîtier (22).

9. Dispositif de connexion électrique selon l'une des revendications 5 à 8,
caractérisé en ce que ledit boîtier (22) et ledit couvercle rigide (9) sont fixés ensemble par des vis (23).

## Patentansprüche

1. Anordnung zum elektrischen Verbinden von gedruckten Leiterplatten, die jeweils auf einer Seite ihres entsprechenden isolierenden Trägers (1,2) Kontakte (3 bis 8, 3' bis 8') zur Verbindung haben,
dadurch gekennzeichnet, daß die Kontakte auf der Seite der Träger, auf der sie angeordnet sind, überstehen, dadurch, daß mindestens der isolierende Träger (2) einer der gedruckten Schaltungen biegsam ist, und dadurch, daß eine Schicht (10) aus einem elastisch verformbaren Material zur Ausübung eines Drucks auf die Seite ohne Kontakte des biegsamen Trägers (2) vorgesehen ist, so daß dieser gegen mindestens einen anderen Träger (1) gedrückt wird, der an einem starren Element (9) anliegt, so daß jeder zu verbindende Kontakt (4,6,8,4',6',8') des biegsamen Trägers (2) mit einem zu verbindenden Kontakt (3,5,7,3',5',7') eines anderen Trägers (1) in Kontakt gebracht wird.

2. Anordnung zum elektrischen Verbinden nach Anspruch 1,
dadurch gekennzeichnet, daß sich die Schicht (10) aus einem elastisch verformbaren Material auf einer starren Druckplatte (11) befindet.

3. Anordnung zum elektrischen Verbinden nach Anspruch 2,
dadurch gekennzeichnet, daß die starre Druckplatte (11) von einer Feder (24) beaufschlagt wird.

4. Anordnung zum elektrischen Verbinden nach einem der Ansprüche 1 bis 3,
dadurch gekennzeichnet, daß die Schicht (10) aus einem elastisch verformbaren Material aus einem Elastomer besteht.

5. Anordnung zum elektrischen Verbinden nach einem der Ansprüche 3 oder 4,
dadurch gekennzeichnet, daß sie einerseits ein Gehäuse (22) mit der starren Druckplatte (11) und der Feder (24), durch das die Schicht (10) aus einem elastisch verformbaren Material freigegeben wird, und andererseits einen starren Deckel (9) hat, der gegenüber der Schicht (10) aus einem elastisch verformbaren Material mit dem Gehäuse (22) gekoppelt werden kann.

6. Anordnung zum elektrischen Verbinden nach Anspruch 5,
dadurch gekennzeichnet, daß das Gehäuse (22) und der starre Deckel (9) zusätzliche Führungsmittel (27,28) haben, durch die die An- und Abstellbewegungen des starren Deckels (9) in Bezug auf das Gehäuse (22) gesteuert werden können.

7. Anordnung zum elektrischen Verbinden nach Anspruch 6,
dadurch gekennzeichnet, daß die zusätzlichen Führungsmittel (27,28) Positionierungsstifte (27) und Aussparungen (28) haben, die jeweils am Gehäuse (22) und am starren Deckel (9) vorgesehen sind.

8. Anordnung zum elektrischen Verbinden nach Anspruch 7,
dadurch gekennzeichnet, daß die Positionierungsstifte (27) durch Bohrungen (29) und (30) verlaufen, die in den isolierenden Trägern 1 bzw. 2 angeordnet sind, damit diese gegenüber dem Gehäuse (22) positioniert werden können.

9. Anordnung zum elektrischen Verbinden nach einem der Ansprüche 5 bis 8,
dadurch gekennzeichnet, daß das Gehäuse (22) und der starre Deckel (9) miteinander durch Schrauben (23) befestigt werden.

## Claims

1. Device for the electrical connection of printed circuits, each of which is provided, on one of the faces of its corresponding insulating supports (1, 2), with contacts (3 to 8, 3' to 8') intended for connection, characterized in that the said contacts project from that face of the said supports which carries them, in that at least the insulating support (2) of one of the said printed circuits is flexible, and in that a layer (10) of elastically deformable material is provided in order to exert pressure on that face of the said flexible support (2) which is not provided with contacts, so as to press it against at least one other (1) of the said supports, which bears against a rigid element (9), so that each contact (4, 6, 8, 4', 6', 8'), intended to be connected, of the said flexible support (2) is brought into contact with a contact (3, 5, 7, 3', 5', 7'), intended to be connected, of another of the said supports (1).

2. Electrical connection device according to Claim 1, characterized in that the said layer (10) of elastically deformable material is carried by a rigid pressure plate (11).

3. Electrical connection device according to Claim 2, characterized in that the said rigid pressure plate (11) is subjected to the action of a spring (24).

4. Electrical connection device according to one of Claims 1 to 3, characterized in that the said layer (10) of elastically deformable material consists of an elastomer.

5. Electrical connection device according to either of Claims 3 and 4, characterized in that it includes, on the one hand, a housing (22) containing the said rigid pressure plate (11) and the said spring (24) and releasing the said layer (10) of elastically deformable material and, on the other hand, a rigid cover (9) which can be joined to the said housing (22) opposite the said layer (10) of elastically deformable material.

6. Electrical connection device according to Claim 5, characterized in that the said housing (22) and the said rigid cover (9) include complementary guide means (27, 28) guiding the approaching and receding movements of the said rigid cover (9) with respect to the said housing (22).

7. Electrical connection device according to Claim 6, characterized in that the said complementary guide means (27, 28) include positioning studs (27) and recesses (28), respectively provided on the said housing (22) and the said rigid cover (9).

8. Electrical connection device according to Claim 7, characterized in that the said positioning studs (27) pass through holes (29) and (30), respectively made in the said insulating supports 1 and 2, so as to position the latter with respect to the said housing (22).

9. Electrical connection device according to one of Claims 5 to 8, characterized in that the said housing (22) and the said rigid cover (9) are fixed together using screws (23).
